(19) Europäisches Patentamt
European Patent Office
Office européen des brevets

(11) **EP 2 088 651 A1**

(12) **EUROPÄISCHE PATENTANMELDUNG**

(43) Veröffentlichungstag:
**12.08.2009 Patentblatt 2009/33**

(51) Int Cl.:
*H01S 5/40* (2006.01)   *G02B 27/09* (2006.01)

(21) Anmeldenummer: **08002444.1**

(22) Anmeldetag: **11.02.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(71) Anmelder: **TRUMPF Laser GmbH + Co. KG**
**78713 Schramberg (DE)**

(72) Erfinder:
• **Strohmeier, Stephan Gregor Patrick**
  **78733 Aichhalden (DE)**
• **Tillkorn, Christoph**
  **78658 Zimmern (DE)**

(74) Vertreter: **Kohler Schmid Möbus**
**Patentanwälte**
**Ruppmannstrasse 27**
**70565 Stuttgart (DE)**

(54) **Diodenlaserstruktur zur Erzeugung von Diodenlaserstrahlung mit faserkopplungsoptimierten Strahlparameterprodukt**

(57)     Bei einer Diodenlaserstruktur (2) mit mehreren nebeneinander angeordneten Streifenemittern ($3_1$ bis $3_8$), die mit ihren SA-Achsen in der gleichen Richtung ausgerichtet und in dieser Richtung versetzt zueinander angeordnet sind, sind erfindungsgemäß die jeweils auf die SA-Achse bezogenen Strahlparameterprodukte ($BPP_{SA}$) zumindest einiger der Streifenemitter ($3_1$ bis $3_8$) verschieden.

Fig. 1

**Beschreibung**

Die vorliegende Erfindung betrifft eine Diodenlaserstruktur mit mehreren parallel nebeneinander angeordneten Streifenemittern, die mit ihren SA-Achsen in der gleichen Richtung ausgerichtet und jeweils in der Richtung ihrer SA-Achsen versetzt zueinander angeordnet sind.

Für die Erzeugung von effizienter und hochbrillanter Diodenstrahlung werden gegenwärtig entweder mehrere Einzelemitter (Breitstreifenemitter mit typischen Breiten von 50 bis 500 $\mu$m) oder Diodenbarren bestehend aus mehreren gleich breiten Einzelemittern/Breitstreifenemittern (Diodenbarren aus typischerweise 10 bis 100 gleich breiten Breitstreifenemittern mit einem Füllfaktor von 10 bis 95%) verwendet. Beispielsweise finden Diodenbarren aus 30 bis 50 Emittern mit einer Breite von 100 $\mu$m auf einem 1 cm Barren mit einem Füllfaktor von 30 bis 50% häufig Verwendung.

Die streifenförmigen Einzelemitter eines Diodenbarrens emittieren jeweils einen Laserstrahl, der sich in einer so genannten FA(Fast Axis)-Richtung, in der der Strahl schnell divergiert, bspw. mit einem Abstrahlwinkel von ca. 50° und in einer dazu rechtwinkligen, so genannten SA(Slow Axis)-Richtung, in der der Strahl vergleichsweise langsam divergiert, bspw. mit einem Abstrahlwinkel von ca. 10°, ausbreitet. Die FA-Richtung weist die höchstmögliche (nahezu beugungsbegrenzte) Strahlqualität, die SA-Richtung hingegen eine relativ schlechte Strahlqualität auf. Um diese Einzelstrahlen zusammenzufassen, werden sie zunächst in der FA-Richtung mittels einer mikrooptischen Zylinderlinse kollimiert und anschließend mit Hilfe einer Zylinderlinsen-Reihe (Array) eine Kollimation in SA-Richtung vorgenommen. Danach werden die Strahlen mittels einer weiteren Mikrooptik um 90° gedreht und nebeneinander angeordnet. Der so geformte Laserstrahl ist also durch bündige optische Stapelung der von den streifenförmigen Einzelemittern emittierten Laserstrahlstreifen gebildet. Da die Einzelemitter identisch sind, weisen ihre emittierten Laserstrahlen jeweils das gleiche auf die SA-Richtung bezogene Strahlparameterprodukt ($BPP_{SA}$) und das gleiche auf die FA-Richtung bezogene Strahlparameterprodukt ($BPP_{FA}$) auf, wobei das Strahlparameterprodukt BPP wie folgt definiert ist:

$$BPP_i = \theta_i * w_i \quad (i = SA, FA)$$

mit

θ:    Divergenz des vom Emitter emittierten Laserstrahls in SA- bzw. FA-Richtung,

w:    halbe Breite des Emitters in SA- bzw. FA-Richtung.

Die bündige optische Stapelung der Laserstrahlstreifen mit jeweils gleichem $BPP_{SA}$ und $BPP_{FA}$ führt zu einem Laserstrahl, der ein in der $BPP_{SA}$-$BPP_{FA}$-Ebene rechteckiges bzw. quadratisches Strahlparameterprodukt aufweist und daher in eine runde Faser, welche ein in der $BPP_{SA}$-$BPP_{FA}$-Ebene rundes Strahlparameterprodukt aufweist, nur mit Strahlungsverlusten oder unter nicht vollständiger Ausnutzung der Faser eingekoppelt wird.

Aus der US 2007/0195850 A1 ist es zwar bekannt, Einzelemitter mit in SA-Richtung unterschiedlichen Emitterbreiten in FA-Richtung übereinander gestapelt anzuordnen und dadurch das auf die SA-Achse bezogene Strahlparameterprodukt jedes Emitters an das auf die SA-Achse bezogene Strahlparameterprodukt des zugehörigen Faserbereichs anzupassen. Allerdings sind das Handling und die Positionierung der einzelnen Emitter sehr aufwändig, und zudem erfordert diese Anordnung einen verhältnismäßig großen Bauraum.

Der Erfindung liegt deshalb die Aufgabe zugrunde, eine Diodenstruktur der eingangs genannten Art, insbesondere bestehend aus einem Diodenbarren mit Einzelemittern oder aber auch gestapelten Diodenbarren mit Einzelemittern in Form eines Diodenstacks, dahingehend weiterzubilden, dass das Strahlparameterprodukt der erzeugten Laserdiodenstrahlung in einfacher Weise und in kompakten Abmessungen an das runde Strahlparameterprodukt einer Faser, in die die Laserdiodenstrahlung eingekoppelt werden soll, angepasst ist.

Diese Aufgabe wird erfindungsgemäß dadurch gelöst, dass die jeweils auf die SA-Achse bezogenen Strahlparameterprodukte zumindest einiger der in SA-Richtung nebeneinander angeordneten Streifenemitter verschieden sind, wobei vorzugsweise das jeweils auf die SA-Achse bezogene Strahlparameterprodukt der Streifenemitter ausgehend von der Mitte der Streifenemitteranordnung zu beiden Rändern der Streifenemitteranordnung hin abnimmt. Alternativ und/oder ergänzend können die Streifenemitter in ihrer Strahlausbreitungsrichtung zueinander versetzt sein.

Erfindungsgemäß weisen zumindest einige der in SA-Richtung nebeneinander angeordneten Streifenemitter unterschiedliche auf die SA-Achse bezogene Strahlparameterprodukte auf, die für eine optimierte Einkopplung in eine runde Faser jeweils an die auf die SA-Achse bezogenen Strahlparameterprodukte der zugehörigen Faserbereiche angepasst sind. Dazu sind die auf die SA-Achse bezogenen Strahlparameterprodukte der Streifenemitter bevorzugt derart gewählt, dass sie zu einem in der $BPP_{SA}$-$BPP_{FA}$-Ebene annähernd runden Strahlparameterprodukt optisch zusammensetzbar sind. Mit anderen Worten wird die Ausgangsstrahlung der Streifenemitter an die Faser in der SA-Richtung BPP-angepasst, so dass die Laserdiodenstrahlung mit hoher Effizienz in die Faser eingekoppelt werden kann. Durch Variation der Strahlparameterprodukte der Streifenemitter können also Ausgangsleistung und/oder Effizienz gesteigert werden. Diese Vorgehensweise ist auch auf andere Faserquerschnitte, wie bspw. elliptische Faserquerschnitte, übertragbar.

Das Strahlparameterprodukt eines Streifenemitters kann über seine Breite und über die Divergenz des emittierten Laserstrahls eingestellt werden. Bei besonders bevorzugten Ausführungsformen sind zumindest einige der Streifenemitter in der Richtung ihrer SA-Achsen verschieden breit, während bei anderen bevorzugten Ausführungsformen zumindest einige der Streifenemitter eine jeweils auf die SA-Achse bezogene unterschiedliche Divergenz aufweisen.

Vorzugsweise sind einer oder mehrere der Streifenemitter jeweils durch einen einzigen Einzelemitter gebildet, so dass die erfindungsgemäße Diodenlaserstruktur unterschiedlich breite Einzelemitter aufweist, die die gleiche oder eine unterschiedliche auf die SA-Achse bezogene Divergenz aufweisen können.

Ebenfalls bevorzugt können einer oder mehrere der Streifenemitter jeweils durch mehrere unterschiedlich breite oder auch gleichbreite Einzelemitter gebildet sein, die die gleiche oder eine unterschiedliche auf die SA-Achse bezogene Divergenz aufweisen können. Besonders bevorzugt sind unterschiedlich breite Streifenemitter jeweils durch eine unterschiedliche Anzahl von identischen Einzelemittern gebildet, wobei in diesem Fall die so gebildeten Streifenemitter die gleiche auf die SA-Achse bezogene Divergenz aufweisen.

Für den Fall einer Einkopplung der Laserdiodenstrahlung in eine Faser ist den Streifenemittern eine Optik nachgeordnet, die die von den Streifenemittern ausgehenden Laserstrahlen als in Richtung ihrer FA-Achsen optisch nebeneinander angeordnete parallele Laserstrahlstreifen auf eine runde Faser abbildet, wobei das auf die SA-Achse bezogene Strahlparameterprodukt jedes Laserstrahlstreifens an das auf die SA-Achse bezogene Strahlparameterprodukt des zugehörigen Faserbereichs angepasst ist, d.h. der Laserstrahlstreifen an seinen zugehörigen Faserbereich in der SA-Richtung BPP-angepasst ist.

Weitere Vorteile der Erfindung ergeben sich aus den Ansprüchen, der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

| | |
|---|---|
| Fig. 1 | einen Diodenlaserbarren mit einer ersten erfindungsgemäßen Diodenlaserstruktur mit mehreren nebeneinander angeordneten, verschieden breiten Streifenemittern; |
| Fign. 2a bis 2c | verschiedene Ausführungsbeispiele zweier verschieden breiter Streifenemitter entsprechend dem Detail II in Fig. 1; |
| Fig. 3 | einen Diodenlaserbarren mit einer zweiten erfindungsgemäßen Diodenlaserstruktur mit mehreren nebeneinander angeordneten, verschieden divergenten Streifenemittern; |
| Fig. 4 | den Strahlengang der von der erfindungsgemäßen Diodenlaserstruktur emittierten und mittels einer Optik in eine Faser eingekoppelten Laserstrahlen; |
| Fig. 5 | in der $BPP_{SA}$-$BPP_{FA}$-Ebene die Strahlparameterprodukte der von den Streifenemittern ausgehenden und übereinander gestapelten Laserstrahlstreifen, deren auf die SA-Achse bezogenen Strahlparameterprodukte an das Strahlparameterprodukt des zugehörigen Faserbereichs angepasst sind; |
| Fign. 6a bis 6e | weitere Barrenstrukturen der erfindungsgemäßen Diodenlaserstruktur; und |
| Fig. 7 | einen Diodenstapel ("Diodenstack") aus mehreren Diodenlaserbarren mit jeweils der in Fig. 1 gezeigten ersten erfindungsgemäßen Diodenlaserstruktur. |

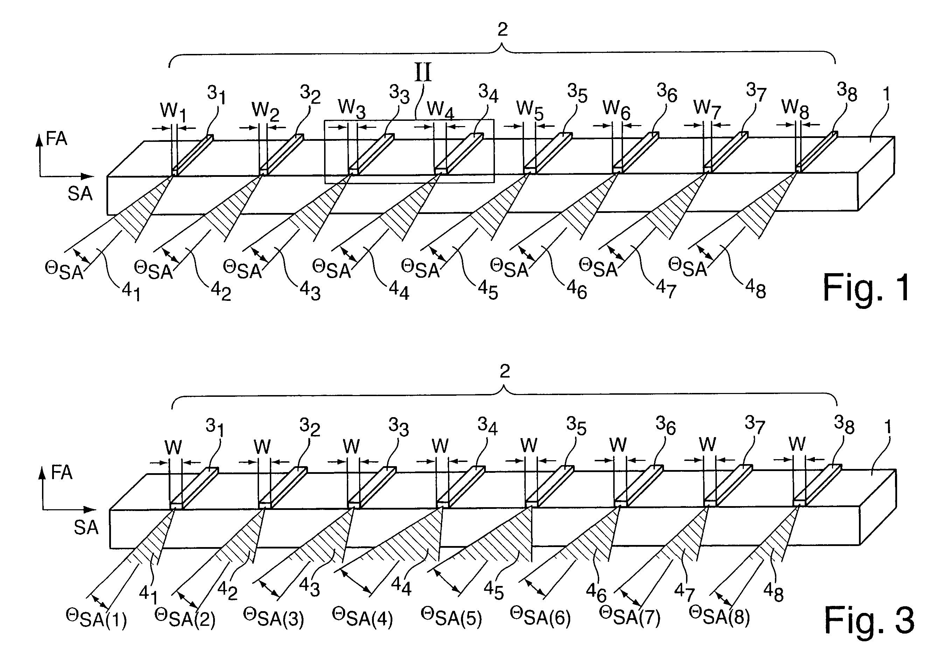

Der in **Fig. 1** gezeigte Diodenlaserbarren **1** weist eine Diodenlaserstruktur **2** mit acht parallel nebeneinander angeordneten Streifenemittern **3$_1$** bis **3$_8$** auf, die mit ihren SA-Achsen in der gleichen, in Fig. 1 waagerechten Richtung ausgerichtet und jeweils in dieser waagerechten Richtung versetzt zueinander angeordnet sind. Einige der Streifenemitter $3_1$ bis $3_8$ weisen in der SA-Richtung unterschiedliche Breiten **w$_1$** bis **w$_8$** auf, wobei die Breite der Streifenemitter $3_1$ bis $3_8$ ausgehend von der Mitte der Diodenlaserstruktur 2 zu beiden Rändern der Diodenlaserstruktur 2 hin abnimmt. Es gilt: $w_4 = w_5 > w_3 = w_6 > w_2 = w_7 > w_1 = w_8$. Beispielsweise beträgt die Breite der zentralen Emitter $3_4$, $3_5$ 50 bis 500 $\mu$m, insbesondere 100 bis 200 $\mu$m. Die Emitterbreite nimmt zu den Rändern hin von Emitter zu Emitter jeweils bis zu 50 %, insbesondere bis zu 30 %, ab. Die Abnahme der Emitterbreite von Emitter zu Emitter kann sowohl relativ als auch absolut gleich oder unterschiedlich sein. Die von den Streifenemittern $3_1$ bis $3_8$ emittierten Laserstrahlen **4$_1$** bis **4$_8$** weisen in der SA-Richtung die gleiche Divergenz $\theta_{SA}$ auf. Entsprechend ist das auf die SA-Richtung bezogene Strahlparameterprodukt $BPP_{SA}(i) = w_{SA}(i)^*\theta_{SA}(i) = w_{SA}(i)^*\theta_{SA}$ ($i = 1, ..., 8$) in der Mitte der Diodenlaserstruktur 2 am größten und nimmt zu den beiden Rändern der Diodenlaserstruktur 2 hin ab, d.h., es gilt: $BPP_{SA}(4) = BPP_{SA}(5) > BPP_{SA}(3) = BPP_{SA}(6) > BPP_{SA}(2) = BPP_{SA}(7) > BPP_{SA}(1) = BPP_{SA}(8)$. Hingegen weisen die

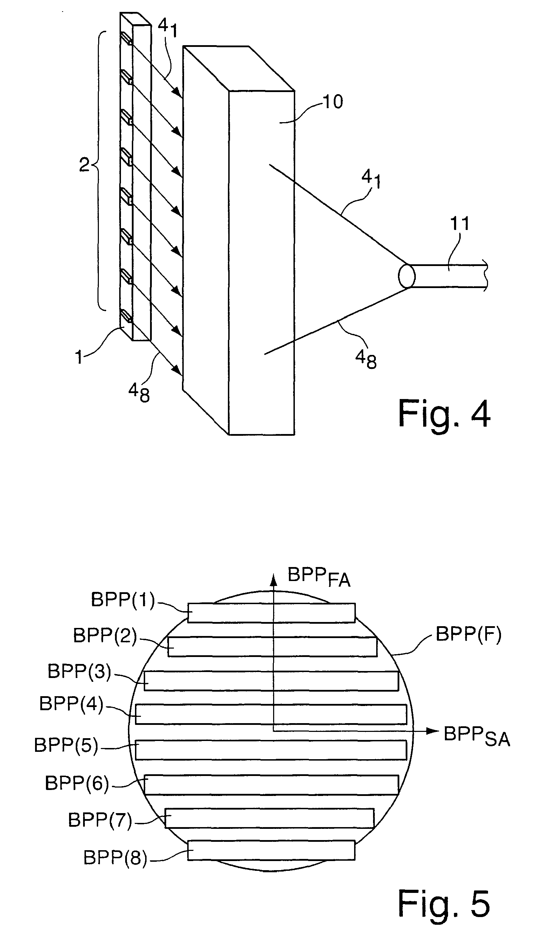

Streifenemitter $3_1$ bis $3_8$ in der FA-Richtung die gleiche Höhe und ihre emittierten Laserstrahlen $4_1$ bis $4_8$ in FA-Richtung die gleiche Divergenz auf. Wie unten mit Bezug auf Fig. 5 noch näher beschrieben wird, sind die auf die SA-Achse bezogenen Strahlparameterprodukte $BPP_{SA}(1)$ bis $BPP_{SA}(8)$ der Streifenemitter $3_1$ bis $3_8$ derart gewählt, dass sie zu einem in der $BPP_{SA}$-$BPP_{FA}$-Ebene annähernd runden Strahlparameterprodukt optisch zusammensetzbar sind.

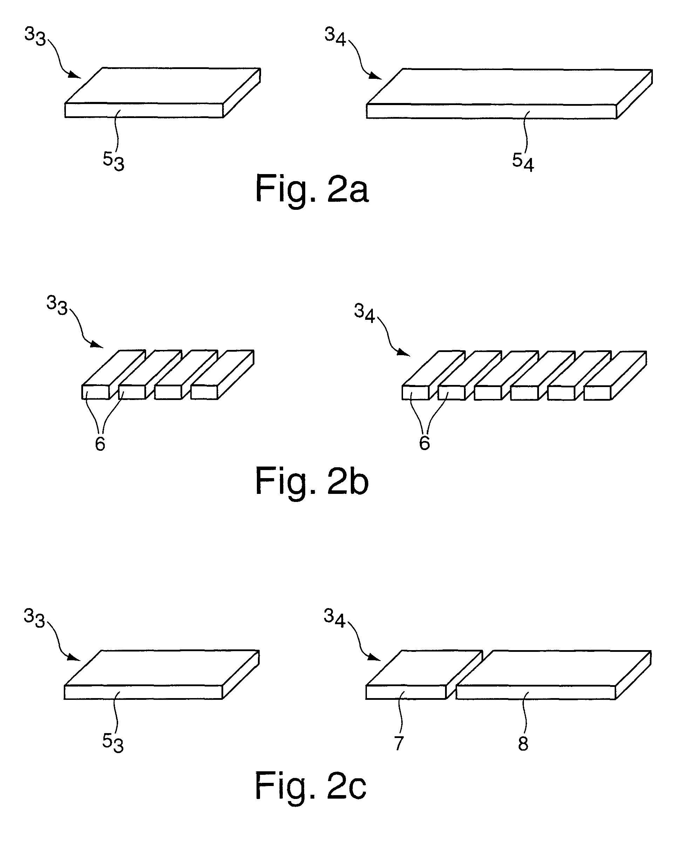

**Fig. 2** zeigt verschiedene Ausführungsbeispiele für die in Fig. 1 gezeigten verschieden breiten Streifenemitter $3_3$, $3_4$. In **Fig. 2a** sind die verschieden breiten Streifenemitter $3_2$, $3_3$ jeweils durch einen einzigen Einzelemitter **$5_3$, $5_4$** gebildet. Alternativ zur Verwendung verschieden breiter Einzelemitter können diese auch durch Gruppen mit einer unterschiedlichen Anzahl von Emittern nachgebildet werden In **Fig. 2b** sind die verschieden breiten Streifenemitter $3_3$, $3_4$ jeweils durch eine unterschiedliche Anzahl von identischen und damit gleichbreiten Einzelemittern **6** gebildet, wodurch für alle Streifenemitter gleiche Schwellströme gewährleistet sind. In **Fig. 2c** ist der breitere Streifenemitter $3_4$ durch zwei unterschiedlich breite Einzelemitter **7, 8** gebildet, was sich bei darzustellenden Streifenemittern mit einer Breite größer 200 μm anbietet.

Vom Diodenlaserbarren der Fig. 1 unterscheidet sich der in **Fig. 3** gezeigte Diodenlaserbarren 1 dadurch, dass hier einige der nebeneinander angeordneten Streifenemitter $3_1$ bis $3_8$ eine jeweils auf die SA-Achse bezogene unterschiedliche Divergenz $\theta_{SA}(1)$ bis $\theta_{SA}(8)$ aufweisen und alle Streifenemitter $3_1$ bis $3_8$ die gleiche Breite **w** aufweisen. Die Divergenz der Streifenemitter $3_1$ bis $3_8$ nimmt ausgehend von der Mitte der Diodenlaserstruktur 2 zu beiden Rändern der Diodenlaserstruktur 2 hin ab. Es gilt: $\theta_{SA}(4) = \theta_{SA}(5) > \theta_{SA}(3) = \theta_{SA}(6) > \theta_{SA}(2) = \theta_{SA}(7) > \theta_{SA}(1) = \theta_{SA}(8)$. Entsprechend ist das auf die SA-Richtung bezogene Strahlparameterprodukt $BPP_{SA}(i) = w(i)*\theta_{SA}(i) = w*\theta_{SA}(i)$ (i= 1, ..., 8) in der Mitte der Diodenlaserstruktur 2 am größten und nimmt zu den beiden Rändern der Diodenlaserstruktur 2 hin ab, d.h., es gilt: $BPP_{SA}(4) = BPP_{SA}(5) > BPP_{SA}(3) = BPP_{SA}(6) > BPP_{SA}(2) = BPP_{SA}(7) > BPP_{SA}(1) = BPP_{SA}(8)$. Wie unten mit Bezug auf Fig. 5 noch näher beschrieben wird, sind die auf die SA-Achse bezogenen Strahlparameterprodukte $BPP_{SA}(1)$ bis $BPP_{SA}(8)$ der Streifenemitter $3_1$ bis $3_8$ derart gewählt, dass sie zu einem in der $BPP_{SA}$-$BPP_{FA}$-Ebene annähernd runden Strahlparameterprodukt optisch zusammensetzbar sind.

**Fig. 4** zeigt schematisch den Strahlengang der von der erfindungsgemäßen Diodenlaserstruktur 2 emittierten und mittels einer Optik **10** in eine runde Faser **11** eingekoppelten Laserstrahlen $4_1$ bis $4_8$. Die Optik 10 transformiert die einzelnen Laserstrahlen $4_1$ bis $4_8$ zu einem gemeinsamen Laserstrahl, in dem die von den Streifenemittern $3_1$ bis $3_8$ ausgehenden Laserstrahlen $4_1$ bis $4_8$ als in Richtung ihrer FA-Achsen übereinander gestapelte parallele Laserstrahlstreifen auf die runde Faser 11 abgebildet werden.

**Fig. 5** zeigt in der $BPP_{SA}$-$BPP_{FA}$-Ebene die Strahlparameterprodukte BPP(1) bis BPP(8) der von den Streifenemittern $3_1$ bis $3_8$ ausgehenden und übereinander gestapelten Laserstrahlstreifen, wobei die Strahlparameterprodukte BPP(1) bis BPP(8) an das runde Strahlparameterprodukt BPP(F) der runden Faser 11 angepasst ist. Dazu sind die Strahlparameterprodukte BPP(1) bis BPP(8) in der SA-Achse an das zugehörige Strahlparameterprodukt des zugehörigen Faserbereichs angepasst. Mit anderen Worten sind die auf die SA-Achse bezogenen Strahlparameterprodukte $BPP_{SA}(1)$ bis $BPP_{SA}(8)$ der Streifenemitter $3_1$ bis $3_8$ derart gewählt, dass sie zu dem in der $BPP_{SA}$-$BPP_{FA}$-Ebene runden Strahlparameterprodukt BPP(F) der Faser 11 optisch zusammengesetzt werden können.

Bei den in Fign. 1 und 3 gezeigten Diodenlaserstrukturen 2 liegen die Auskoppelflächen der Streifenemitter $3_1$ bis $3_8$ in einer gemeinsamen Ebene rechtwinklig zur Ausbreitungsrichtung der von den Streifenemittern $3_1$ bis $3_8$ ausgehenden Laserstrahlen $4_1$ bis $4_8$. **Fign. 6a bis 6e** zeigen weitere Diodenlaserstrukturen 2 von erfindungsgemäßen Diodenlaserbarren 1, bei denen die Auskoppelflächen der Streifenemitter $3_1$ bis $3_8$ nicht in einer gemeinsamen Ebene rechtwinklig zur Ausbreitungsrichtung der von den Streifenemittern $3_1$ bis $3_8$ ausgehenden Laserstrahlen $4_1$ bis $4_8$ liegen.

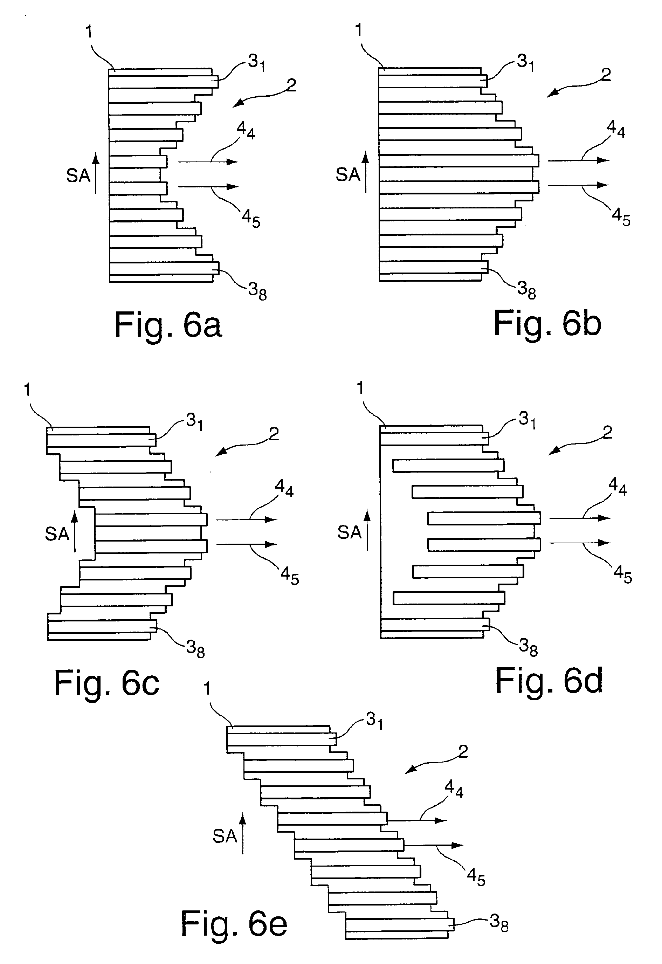

In Fign. 6a und 6b sind die Auskoppelflächen der Streifenemitter $3_1$ bis $3_8$ mit ihren den Auskoppelflächen abgewandten Enden in einer gemeinsamen Ebene angeordnet, aber in Richtung rechtwinklig zu ihren SA- und FA-Richtungen unterschiedlich lang. Die Länge der Streifenemitter $3_1$ bis $3_8$ nimmt ausgehend von der Mitte der Diodenlaserstruktur 2 zu beiden Rändern der Diodenlaserstruktur 2 hin zu (Fig. 6a) oder ab (Fig. 6b), wodurch die Auskoppelflächen der Streifenemitter $3_1$ bis $3_8$ ausgehend von der Mitte der Diodenlaserstruktur 2 beidseitig in SA-Richtung treppenförmig zueinander versetzt sind.

In Fign. 6c und 6d sind die Streifenemitter $3_1$ bis $3_8$ in Richtung rechtwinklig zu ihren SA- und FA-Richtungen gleich lang und jeweils beidseitig in SA-Richtung treppenförmig zueinander versetzt angeordnet, wodurch ihre Auskoppelflächen ausgehend von der Mitte der Diodenlaserstruktur 2 beidseitig in SA-Richtung treppenförmig zueinander versetzt sind. Während in Fig. 6c der Diodenlaserbarren 1 auf der den Auskoppelflächen der Streifenemitter $3_1$ bis $3_8$ abgewandten Seite entsprechend den Streifenemittern $3_1$ bis $3_8$ ebenfalls treppenförmig ausgebildet ist, ist in Fig. 6d der Diodenlaserbarren 1 auf der den Auskoppelflächen der Streifenemitter $3_1$ bis $3_8$ abgewandten Seite nicht treppenförmig ausgebildet.

In Fig. 6e sind identische Streifenemitter $3_1$ bis $3_8$ jeweils zueinander in SA-Richtung treppenförmig versetzt angeordnet.

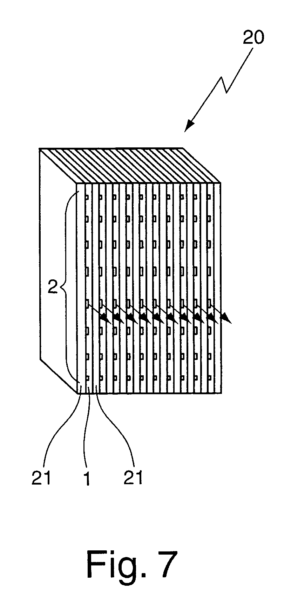

In **Fig. 7** sind mehrere Diodenlaserbarren 1 mit der in Fig. 1 gezeigten Diodenstruktur 2 zu einem Diodenstapel ("Diodenstack") **20** zusammengesetzt, wobei jeder Diodenlaserbarren 1 zwischen zwei Wärmesenken **21** angeordnet ist.

## Patentansprüche

1. Diodenlaserstruktur (2) mit mehreren nebeneinander angeordneten Streifenemittern ($3_1$ bis $3_8$), die mit ihren SA-Achsen in der gleichen Richtung ausgerichtet und in dieser Richtung versetzt zueinander angeordnet sind,
   **dadurch gekennzeichnet,**
   **dass** die jeweils auf die SA-Achse bezogenen Strahlparameterprodukte ($BPP_{SA}$) zumindest einiger der Streifenemitter ($3_1$ bis $3_8$) verschieden sind.

2. Diodenlaserstruktur nach Anspruch 1, **dadurch gekennzeichnet, dass** die auf die SA-Achse bezogenen Strahlparameterprodukte ($BPP_{SA}$) der Streifenemitter ($3_1$ bis $3_8$) derart gewählt sind, dass sie zu einem in der $BPP_{SA}$-$BPP_{FA}$-Ebene annähernd dem Strahlparameterprodukt einer Faser entsprechenden Strahl entsprechend dem Faserquerschnitt, insbesondere einem runden oder elliptischen Faserquerschnitt, optisch zusammensetzbar sind.

3. Diodenlaserstruktur nach Anspruch 1 oder 2, **dadurch gekennzeichnet, dass** die Auskoppelflächen der Streifenemitter ($3_1$ bis $3_8$) in einer Ebene rechtwinklig zur Ausbreitungsrichtung der von den Streifenemittern ($3_1$ bis $3_8$) ausgehenden Laserstrahlen ($4_1$ bis $4_8$) liegen oder zumindest einige der Auskoppelflächen der Streifenemitter ($3_1$ bis $3_8$) treppenförmig zueinander versetzt angeordnet sind.

4. Diodenlaserstruktur nach einem der vorhergehenden Ansprüche, **dadurch gekennzeichnet, dass** das jeweils auf die SA-Achse bezogene Strahlparameterprodukt ($BPP_{SA}$) der Streifenemitter ($3_1$ bis $3_8$) ausgehend von der Mitte der Diodenlaserstruktur (2) zu beiden Rändern der Diodenlaserstruktur (2) hin abnimmt.

5. Diodenlaserstruktur nach einem der vorhergehenden Ansprüche, **dadurch gekennzeichnet, dass** zumindest einige der Streifenemitter ($3_1$ bis $3_8$) in der Richtung ihrer SA-Achsen verschieden breit sind.

6. Diodenlaserstruktur nach Anspruch 4, **dadurch gekennzeichnet, dass** die Breite ($w_1$ bis $w_8$) der Streifenemitter ($3_1$ bis $3_8$) ausgehend von der Mitte der Diodenlaserstruktur (2) zu beiden Rändern der Diodenlaserstruktur (2) hin abnimmt.

7. Diodenlaserstruktur nach einem der vorhergehenden Ansprüche, **dadurch gekennzeichnet, dass** zumindest einige der Streifenemitter ($3_1$ bis $3_8$) eine jeweils auf die SA-Achse bezogene unterschiedliche Divergenz ($\theta_{SA}$) aufweisen.

8. Diodenlaserstruktur nach Anspruch 6, **dadurch gekennzeichnet, dass** die auf die SA-Achse bezogene Divergenz ($\theta_{SA}$) der Streifenemitter ($3_1$ bis $3_8$) ausgehend von der Mitte der Diodenlaserstruktur (2) zu beiden Rändern der Diodenlaserstruktur (2) hin abnimmt.

9. Diodenlaserstruktur nach einem der vorhergehenden Ansprüche, **dadurch gekennzeichnet, dass** einer oder mehrere der Streifenemitter ($3_1$ bis $3_8$) jeweils durch einen einzigen Einzelemitter ($5_3$, $5_4$) gebildet sind.

10. Diodenlaserstruktur nach einem der vorhergehenden Ansprüche, **dadurch gekennzeichnet, dass** einer oder mehrere der Streifenemitter ($3_1$ bis $3_8$) jeweils durch mehrere Einzelemitter (6, 7, 8) gebildet sind.

11. Diodenlaserstruktur nach Anspruch 9, **dadurch gekennzeichnet, dass** unterschiedlich breite Streifenemitter ($3_1$ bis $3_8$) jeweils durch eine unterschiedliche Anzahl von gleichbreiten, insbesondere identischen Einzelemittern (6) gebildet sind.

12. Diodenlaserstruktur nach Anspruch 9, **dadurch gekennzeichnet, dass** unterschiedlich breite Streifenemitter ($3_1$ bis $3_8$) jeweils durch mehrere unterschiedlich breite Einzelemitter (7, 8) gebildet sind.

13. Diodenlaserstruktur nach einem der vorhergehenden Ansprüche, **dadurch gekennzeichnet, dass** den Streifenemittern ($3_1$ bis $3_8$) eine Optik (10) nachgeordnet ist, die die von den Streifenemittern ($3_1$ bis $3_8$) ausgehenden Laserstrahlen ($4_1$ bis $4_8$) als in Richtung ihrer FA-Achsen optisch nebeneinander angeordnete parallele Laserstrahlstreifen auf eine runde Faser (11) abbildet, wobei das auf die SA-Achse bezogene Strahlparameterprodukt ($BPP_{SA}$) jedes Laserstrahlstreifens an das auf die SA-Achse bezogene Strahlparameterprodukt ($BPP_{SA}$) des zugehörigen Faserbereichs angepasst ist.

14. Diodenlaserstruktur nach einem der vorhergehenden Ansprüche, **dadurch gekennzeichnet, dass** die Streifenemitter ($3_1$ bis $3_8$) auf einem Laserdiodenbarren (1) angeordnet sind.

15. Diodenlaserstruktur nach Anspruch 14, **dadurch gekennzeichnet, dass** mehrere Laserdiodenbarren (1) zu einem Diodenstapel (20) gestapelt sind.

Fig. 1

Fig. 3

EP 2 088 651 A1

$3_3$

$5_3$

$3_4$

$5_4$

# Fig. 2a

$3_3$

6

$3_4$

6

# Fig. 2b

$3_3$

$5_3$

$3_4$

7      8

# Fig. 2c

Fig. 4

Fig. 5

Fig. 6a

Fig. 6b

Fig. 6c

Fig. 6d

Fig. 6e

Fig. 7

Europäisches
Patentamt

European
Patent Office

Office européen
des brevets

**EUROPÄISCHER RECHERCHENBERICHT**

**Nummer der Anmeldung**

EP 08 00 2444

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 5 565 693 A (SASAKI TATSUYA [JP] ET AL) 15. Oktober 1996 (1996-10-15) * Abbildung 25 * ----- | 1,2,5,7, 9-15 | INV. H01S5/40 G02B27/09 |
| X | JP 2007 214300 A (SONY CORP) 23. August 2007 (2007-08-23) * Zusammenfassung * ----- | 1,2,5,7, 9-15 | |
| X | JP 05 110187 A (MATSUSHITA ELECTRIC IND CO LTD) 30. April 1993 (1993-04-30) * Zusammenfassung * ----- | 1,2,5,7, 9-15 | |
| X | JP 06 132610 A (NIPPON TELEGRAPH & TELEPHONE) 13. Mai 1994 (1994-05-13) * Zusammenfassung * ----- | 1,2,5,7, 9-15 | |
| A | US 2004/190580 A1 (PEZESHKI BARDIA [US] ET AL) 30. September 2004 (2004-09-30) * Absatz [0041] * ----- | 1,2,4-15 | |
| A | JP 2007 324312 A (SONY CORP) 13. Dezember 2007 (2007-12-13) * Abbildungen 1-17 * ----- | 9-12 | RECHERCHIERTE SACHGEBIETE (IPC) G02B H01S |
| D,A | US 2007/195850 A1 (SCHLUTER HOLGER [US] ET AL) 23. August 2007 (2007-08-23) * das ganze Dokument * ----- | 1-15 | |
| X | US 2004/233964 A1 (YAMANAKA FUSAO [JP] ET AL) 25. November 2004 (2004-11-25) * Abbildung 24 * ----- | 3 | |
| X | JP 2003 344803 A (TOYODA MACHINE WORKS LTD) 3. Dezember 2003 (2003-12-03) * Abbildung 16 * ----- | 3 | |
| A | US 6 240 116 B1 (LANG ROBERT J [US] ET AL) 29. Mai 2001 (2001-05-29) * Abbildungen 6,14,15 * ----- | 3 | |

Der vorliegende Recherchenbericht wurde für alle Patentansprüche erstellt

| Recherchenort | Abschlußdatum der Recherche | Prüfer |
|---|---|---|
| München | 6. Februar 2009 | Jobst, Bernhard |

EPO FORM 1503 03.82 (P04C03)

Europäisches
Patentamt

European
Patent Office

Office européen
des brevets

## GEBÜHRENPFLICHTIGE PATENTANSPRÜCHE

Die vorliegende europäische Patentanmeldung enthielt bei ihrer Einreichung Patentansprüche, für die eine Zahlung fällig war.

☐ Nur ein Teil der Anspruchsgebühren wurde innerhalb der vorgeschriebenen Frist entrichtet. Der vorliegende europäische Recherchenbericht wurde für jene Patentansprüche erstellt, für die keine Zahlung fällig war, sowie für die Patentansprüche, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die Patentansprüche erstellt, für die keine Zahlung fällig war.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

Siehe Ergänzungsblatt B

☒ Alle weiteren Recherchengebühren wurden innerhalb der gesetzten Frist entrichtet. Der vorliegende europäische Recherchenbericht wurde für alle Patentansprüche erstellt.

☐ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

☐ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

☐ Der vorliegende ergänzende europäische Recherchenbericht wurde für die Teile der Anmeldung erstellt, die sich auf die zuerst in den Patentansprüchen erwähnte Erfindung beziehen (Regel 164 (1) EPÜ).

Europäisches
Patentamt
European
Patent Office
Office européen
des brevets

**MANGELNDE EINHEITLICHKEIT
DER ERFINDUNG
ERGÄNZUNGSBLATT B**

**Nummer der Anmeldung**

EP 08 00 2444

Nach Auffassung der Recherchenabteilung entspricht die vorliegendeeuropäische Patentanmeldung nicht den Anforderungen an die Einheitlichkeit der Erfindungund enthält mehrere Erfindungen oder Gruppen von Erfindungen, nämlich:

1. Ansprüche: 1,2,4-15

   Der Gegenstand der Ansprüche 1, 2, 4-15 betrifft eine Diodenlaserstruktur mit Streifenemittern mit unterschiedlichen Strahlparameterprodukten.
   ---

2. Anspruch: 3

   Der Gegenstand von Anspruch 3 in der zweiten darin genannten Alternative im Lichte der Beschreibung S. 3, Z. 27-28, die die Alternative als vollständige Alternative zu Anspruch 1 beschreibt.
   ---

**ANHANG ZUM EUROPÄISCHEN RECHERCHENBERICHT**
**ÜBER DIE EUROPÄISCHE PATENTANMELDUNG NR.**

EP 08 00 2444

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

06-02-2009

| Im Recherchenbericht angeführtes Patentdokument | | Datum der Veröffentlichung | Mitglied(er) der Patentfamilie | | Datum der Veröffentlichung |
|---|---|---|---|---|---|
| US 5565693 | A | 15-10-1996 | DE<br>DE<br>EP | 69407312 D1<br>69407312 T2<br>0606093 A2 | 29-01-1998<br>23-07-1998<br>13-07-1994 |
| JP 2007214300 | A | 23-08-2007 | KEINE | | |
| JP 5110187 | A | 30-04-1993 | KEINE | | |
| JP 6132610 | A | 13-05-1994 | KEINE | | |
| US 2004190580 | A1 | 30-09-2004 | KEINE | | |
| JP 2007324312 | A | 13-12-2007 | KEINE | | |
| US 2007195850 | A1 | 23-08-2007 | KEINE | | |
| US 2004233964 | A1 | 25-11-2004 | JP | 2004258624 A | 16-09-2004 |
| JP 2003344803 | A | 03-12-2003 | JP | 3930405 B2 | 13-06-2007 |
| US 6240116 | B1 | 29-05-2001 | KEINE | | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20070195850 A1